# FASCICULE DE BREVET EUROPEEN

(11) **EP 3 206 469 B1**
(45) Date de publication et mention de la délivrance du brevet: **09.01.2019**
(21) Numéro de dépôt: 17155730.9
(22) Date de dépôt: 10.02.2017
(51) Int. Cl.: H05K 7/14, H05K 7/20

(54) **DISPOSITIF DE SUPPORT D'AU MOINS DEUX CARTES ÉLECTRONIQUES, MODULE ÉLECTRONIQUE ET SYSTÈME ÉLECTRONIQUE ASSOCIÉS**
HALTERUNGSVORRICHTUNG FÜR MINDESTENS ZWEI LEITERPLATTEN, ENTSPRECHENDES ELEKTRONISCHES MODUL UND ENTSPRECHENDES ELEKTRONISCHES SYSTEM
DEVICE FOR SUPPORTING AT LEAST TWO ELECTRONIC CARDS, ASSOCIATED ELECTRONIC MODULE AND ELECTRONIC SYSTEM

(30) Priorité: 11.02.2016 FR 1651111
(43) Date de publication de la demande: 16.08.2017
(73) Titulaire: ALSTOM Transport Technologies, 93400 Saint-Ouen (FR)
(72) Inventeur: BLANCHET, Damien, 69780 MIONS (FR); ZANETTI, Adrien, 69100 VILLEURBANNE (FR)
(74) Mandataire: Lavoix

(56) Documents cités:
- FR-A1- 2 764 473
- US-A- 4 916 575
- US-A- 6 151 215
- US-B1- 6 510 053

## Description

La présente invention concerne un dispositif de support d'au moins deux cartes électroniques, le dispositif de support étant destiné à être inséré dans un châssis.

L'invention concerne également un module électronique comprenant au moins deux cartes électroniques et un tel dispositif de support des cartes électroniques.

L'invention concerne également un système électronique comprenant un châssis et au moins un tel module électronique, les cartes électroniques dudit module étant montées dans le châssis par l'intermédiaire du dispositif de support et étant portées par ledit dispositif de support.

L'invention concerne alors le domaine des systèmes électroniques avec un châssis et des cartes électroniques destinées à être insérées dans le châssis, le châssis étant de préférence au format 3U ou 6U.

L'invention concerne notamment le domaine des systèmes électroniques embarqués, en particulier des systèmes électroniques embarqués à bord d'un véhicule, tel qu'un véhicule ferroviaire.

Par exemple, FR 2 764 473 A1 décrit un tiroir électronique et US 4 916 575 A décrit une carte électronique avec une pluralité de circuits.

1U est une unité de longueur bien connue et définie selon la norme Eurocard, ou IEC-60297-3, ou encore selon les normes IEEE 1101.1, IEEE 1101.10 et IEEE 1101.11. 1U correspond à une longueur égale à 44,45 mm, c'est-à-dire égale à 1,75 pouces (de l'anglais *inch).*

Le format 3U correspond alors à une hauteur de châssis égale à 133,35 mm, soit 5,25 pouces, les cartes électroniques destinées au format 3U ayant alors une hauteur sensiblement égale à 100 mm. Le format 6U correspond à une hauteur de châssis égal à 266,70 mm, soit 10,5 pouces, les cartes électroniques destinées au format 6U ayant alors une hauteur sensiblement égale à 233,35 mm.

On connaît du document US 2006/0171119 A1 un adaptateur mécanique permettant de fixer l'une à l'autre deux cartes électroniques au format 3U pour former un ensemble électronique au format 6U, les cartes électroniques étant maintenues dans un même plan vertical par cet adaptateur. L'ensemble électronique, comportant les deux cartes électroniques et l'adaptateur, est alors insérable dans un châssis au format 6U.

L'homme du métier observera en effet que la somme de deux hauteurs de cartes destinées au format 3U est sensiblement égale à 200 mm, soit 33,35 mm de moins qu'une carte destinée au format 6U, ce qui permet d'avoir alors un tel adaptateur ayant une hauteur sensiblement égale à 33,35 mm.

Les cartes électroniques sont ainsi fixées l'une au-dessus de l'autre, et l'adaptateur comprend en outre un radiateur pour dissiper l'énergie thermique libérée par les cartes électroniques lors de leur fonctionnement.

Toutefois, un tel ensemble électronique est relativement fragile, et les cartes électroniques de cet ensemble ne sont en outre pas toujours bien refroidies malgré la présence du radiateur sur l'adaptateur mécanique.

Le but de l'invention est donc de proposer un dispositif de support d'au moins deux cartes électroniques permettant d'avoir un ensemble qui soit plus robuste lorsque les cartes électroniques sont maintenues par le dispositif de support.

À cet effet, l'invention a pour objet un dispositif de support d'au moins deux cartes électroniques, selon la revendication 1.

Le dispositif de support selon l'invention permet alors d'améliorer la robustesse mécanique de par la présence de l'âme configurée pour être agencée entre les cartes électroniques et pour maintenir les cartes électroniques dans des plans distincts, avec une face d'une carte électronique disposée en regard d'une face correspondante d'une autre carte électronique.

Suivant d'autres aspects avantageux de l'invention, le dispositif de support est selon l'une quelconque des revendications 2 à 7.

Lorsque l'âme comporte deux faces d'appui, chaque face d'appui étant munie d'un bord de fixation d'une carte électronique respective, la robustesse mécanique est encore améliorée, chaque carte électronique étant alors maintenue sur l'ensemble de son bord périphérique en contact avec la face d'appui correspondante de l'âme.

Lorsque l'âme est en outre réalisée en un matériau thermiquement conducteur, le dispositif de support permet alors d'améliorer le refroidissement des cartes électroniques lors de leur fonctionnement, en véhiculant, par conduction en direction du châssis, l'énergie thermique dissipée par les cartes électroniques.

L'invention a également pour objet un module électronique selon la revendication 8.

L'invention a également pour objet un système électronique selon la revendication 9.

Suivant un autre aspect avantageux de l'invention, le système électronique est selon la revendication 10.

Ces caractéristiques et avantages de l'invention apparaitront à la lecture de la description qui va suivre, donnée uniquement à titre d'exemple non limitatif, et faite en référence aux dessins annexés, sur lesquels :
- la figure 1 est une représentation schématique d'un système électronique comprenant un châssis et un module électronique, le module électronique comportant deux cartes électroniques et un dispositif de support des cartes électroniques, les cartes dudit module étant montées dans le châssis par l'intermédiaire du dispositif de support et étant portées par ledit dispositif de support,
- la figure 2 est une vue en coupe du module électronique selon le plan II de la figure 1 selon un premier mode de réalisation de l'invention,
- la figure 3 est une vue de côté du module électronique de la figure 1,
- la figure 4 est une vue analogue à celle de la figure 3 selon une variante de réalisation,
- la figure 5 est une vue analogue à celle de la figure 2 selon une variante de réalisation,
- la figure 6 est une vue analogue à celle de la figure 2 avec un agencement différent des cartes électroniques par rapport au dispositif de support, et
- la figure 7 est une vue en coupe transversale de deux dispositifs de support fixés l'un à l'autre.

Dans la suite de la description, les termes « avant », « arrière », « droite », « gauche », « haut », « bas », « longitudinal », « transversal » et « vertical » s'entendent par référence au système d'axe orthogonal usuel, représenté sur certaines figures et possédant :
- un axe longitudinal X dirigé de l'arrière vers l'avant ;
- un axe transversal Y dirigé de la droite vers la gauche ; et
- un axe vertical Z, dirigé du bas vers le haut.

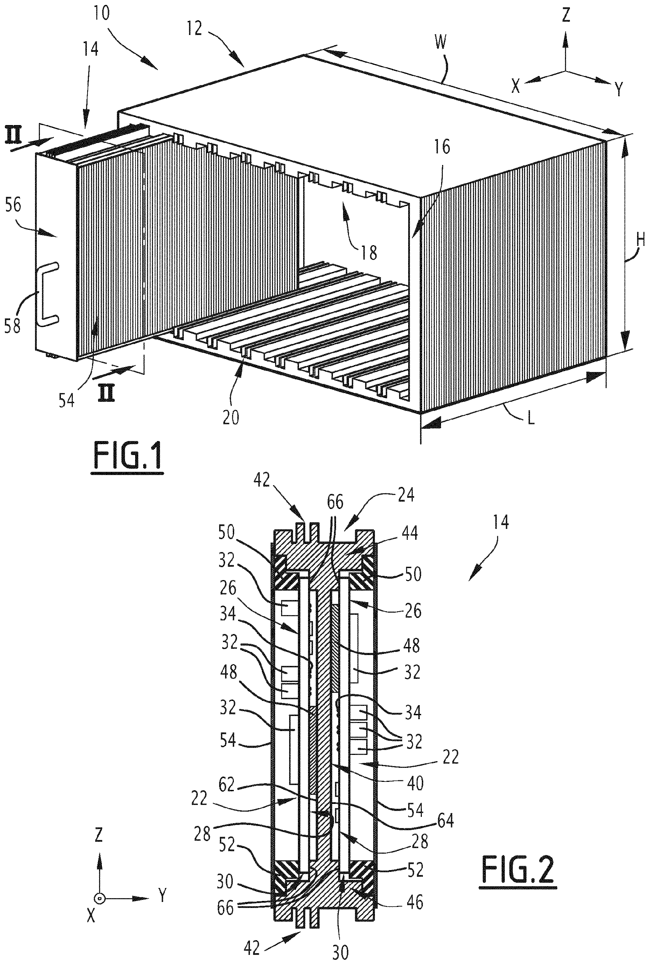

Sur la figure 1, un système électronique 10 comprend un châssis 12 et un module électronique 14. Le système électronique 10 est, par exemple, un système avec un châssis 12 au format 3U ou encore au format 6U au sens de la norme Eurocard, ou IEC-60297-3, ou encore selon les normes IEEE 1101.1, IEEE 1101.10 et IEEE 1101.11.

Le système électronique 10 est de préférence un système électronique embarqué, notamment un système embarqué à bord d'un véhicule, tel qu'un véhicule ferroviaire.

Le châssis 12 comporte à l'avant une ouverture 16 pour recevoir le ou les modules électroniques 14, et à l'arrière une carte de fond de plancher 18 (de l'anglais *backplane*)*,* également appelée carte de fond de panier, pour connecter électriquement le ou les modules électroniques 14, voire pour interconnecter électriquement les modules électroniques 14 entre eux. L'ouverture 16 est de préférence rectangulaire.

Le châssis 12 comporte des premières rainures 20 pour guider chaque module électronique 14 depuis l'ouverture 16 jusqu'à la carte de fond de plancher 18.

Le châssis 12 est de préférence réalisé en un matériau thermiquement conducteur, pour faciliter l'évacuation vers l'extérieur de la chaleur dissipée par le ou les modules électroniques 14. Le châssis 12 est par exemple réalisé en aluminium.

Le châssis 12 est par exemple en forme d'un parallélépipède rectangle, avec une hauteur H selon l'axe vertical Z, une longueur L selon l'axe longitudinal X et une largeur W selon l'axe transversal Y.

La hauteur H est de préférence compatible avec le format 3U ou 6U. La longueur L correspond à la profondeur du châssis 12, et est légèrement supérieure à la longueur de chaque module 14 selon l'axe longitudinal X. La largeur W est variable, et dépend du nombre de modules électroniques 14 destinés à être insérés dans le châssis 12.

La hauteur H est, par exemple, sensiblement égale à 133,35 mm dans le cas d'un format 3U ou sensiblement égale à 266,70 mm dans le cas d'un format 6U. La longueur L est par exemple égale à 24 cm, et la largeur W est de préférence comprise entre 15 cm et 45 cm.

Au moins un module électronique 14 comprend au moins deux cartes électroniques 22 et un dispositif 24 de support des cartes électroniques.

De préférence, chaque module électronique 14 comprend au moins deux cartes électroniques 22 et un dispositif de support 24 respectif, les cartes électroniques 22 étant alors portées par ledit dispositif de support 24.

Dans l'exemple de la figure 2, le module électronique 14 comprend exactement deux cartes électroniques 22 portées par le dispositif de support 24.

Les cartes électroniques 22 de chaque module électronique 14 selon l'invention sont montées dans le châssis 12 par l'intermédiaire d'un dispositif de support 24 respectif, et sont portées par ledit dispositif de support 24. L'homme du métier observera qu'une carte électronique 22 est optionnelle, le dispositif de support 24 étant bien entendu également apte à supporter une seule carte électronique 22 lorsqu'une seule carte électronique 22 est présente.

Chaque carte électronique 22 est connue en soi, et est de préférence compatible avec le châssis 12 d'un type choisi parmi le type 3U et le type 6U au sens de la norme Eurocard, ou IEC-60297-3, ou encore selon les normes IEEE 1101.1, IEEE 1101.10 et IEEE 1101.11.

Chaque carte électronique 22 comporte un circuit imprimé 25 avec une première face 26, une deuxième face 28 et un bord périphérique 30 entre les première et deuxième faces 26, 28, et des composants 32 connectés électriquement au circuit imprimé 25, par exemple via des soudures 34.

Dans l'exemple des figures 1 et 2, chaque carte électronique 22 s'étend sensiblement dans un plan vertical comportant l'axe longitudinal X et l'axe vertical Z. Chaque face 26, 28 s'étend alors dans ledit plan vertical. Chaque face 26, 28 est sensiblement plane.

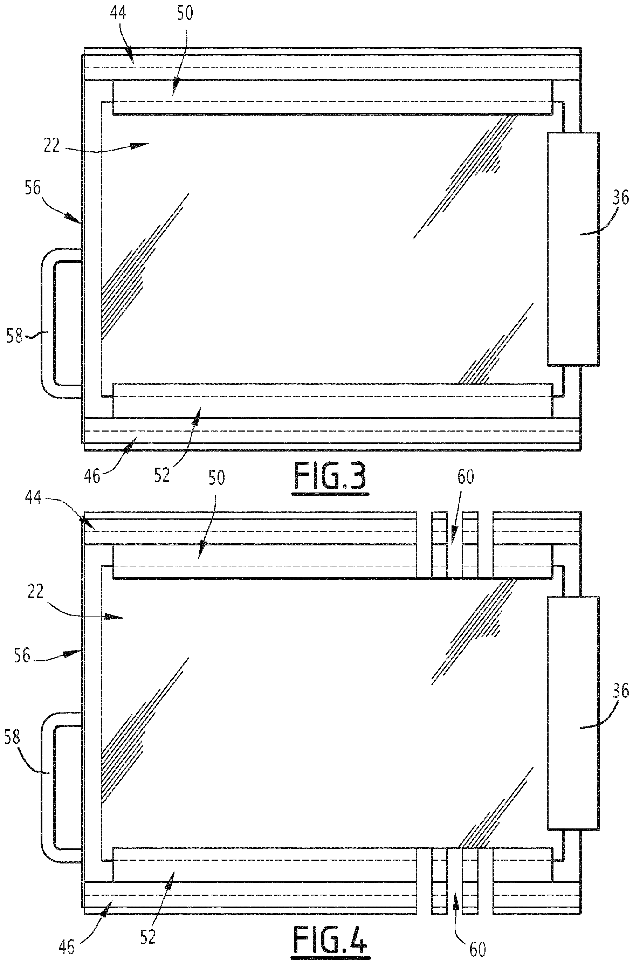

Chaque carte électronique 22 comporte en outre un connecteur arrière 36, visible sur les figure 3 et 4, pour sa connexion électrique avec la carte de fond de plancher 18. Les figures 3 et 4 sont des vues de côté depuis la gauche vers la droite du module électronique 14 selon l'axe transversal Y.

Le dispositif de support 24 est destiné à être inséré dans le châssis 12, et comprend une âme 40 configurée pour être agencée entre les cartes électroniques 22 et pour maintenir les cartes électroniques 22 dans des plans distincts, avec une face 26, 28 d'une carte électronique 22 disposée en regard d'une face 26, 28 correspondante d'une autre carte électronique 22.

Le dispositif de support 24 est configuré pour être en appui mécanique contre le châssis 12, en l'absence d'un contact entre l'une quelconque des cartes électroniques 22 et le châssis 12.

En complément facultatif, le dispositif de support 24 est configuré pour être inséré par coulissement dans le châssis 12, et comprend au moins une deuxième rainure 42 apte à coopérer avec une première rainure 20 complémentaire du châssis 12.

En complément facultatif, le dispositif de support 24 comprend en outre au moins un flanc 44, 46, chaque flanc 44, 46 s'étendant sensiblement perpendiculairement à l'âme 40 et débordant par rapport à l'âme 40 pour protéger un bord de la carte électronique 22 correspondante.

Dans l'exemple de la figure 2, le dispositif de support 24 comprend un flanc supérieur 44 et un flanc inférieur 46, le flanc supérieur 44 étant fixé à une extrémité supérieure de l'âme 40 et le flanc inférieur 46 étant fixé à une extrémité inférieure de l'âme 40.

Le dispositif de support 24 présente alors une section transversale en forme de I, ou encore en forme de H renversé, suivant un plan transversal comportant l'axe transversal Y et l'axe vertical Z.

En complément facultatif, le dispositif de support 24 comprend en outre au moins un tampon 48 thermiquement conducteur et électriquement isolant, chaque tampon 48 étant fixé à l'âme 40 et étant configuré pour être en regard d'au moins un composant 32 d'une carte électronique 22 respective.

Dans l'exemple de la figure 2, le dispositif de support 24 comprend deux tampons 48 fixés de part et d'autre de l'âme 40, chaque tampon 48 étant prévu pour une carte électronique 22 respective et disposé en regard du composant 32 dissipant le plus d'énergie thermique, tel qu'un composant de type processeur, avec par exemple un boîtier de type BGA (de l'anglais *Bail Grid Array*)*.*

En complément facultatif, le dispositif de support 24 comprend en outre au moins une bride de fixation 50, 52, réalisée en un matériau absorbeur de vibrations mécaniques, chaque bride de fixation 50, 52 étant configurée pour maintenir une carte électronique 22 correspondante en contact avec l'âme 40.

Le dispositif de support 24 comprend de préférence une bride supérieure de fixation 50 et une bride inférieure de fixation 52, configurées pour maintenir la carte électronique 22 correspondante par son bord supérieur et respectivement par son bord inférieur en contact avec l'âme 40. Chaque bride de fixation 50, 52 s'étend suivant l'axe longitudinal X.

Dans l'exemple de la figure 2, le dispositif de support 24 comprend deux brides supérieures de fixation 50 et deux brides inférieures de fixation 52, à savoir une bride supérieure de fixation 50 et une bride inférieure de fixation 52 pour chacune des deux cartes électroniques 22.

En complément facultatif, le dispositif de support 24 comprend en outre au moins un capot 54 de protection de la carte électronique. Dans l'exemple de la figure 2, le dispositif de support 24 comprend deux capots de protection 54, à savoir un capot de protection 54 pour chaque carte électronique 22.

En complément facultatif, le dispositif de support 24 comprend en outre une face avant 56 équipée d'une poignée de préhension 58 pour faciliter l'extraction du module électronique 14 par rapport aux châssis 12. La face avant 56 est par exemple fixée au flanc supérieur 44 et au flanc inférieur 46.

En complément facultatif, comme représenté sur la figure 4 illustrant une variante de réalisation, le dispositif de support 24 comprend en outre des rainures de refroidissement 60, ménagées par exemple dans le flanc supérieur 44 et/ou dans le flanc inférieur 46, voire partiellement dans l'âme 40, pour améliorer encore le refroidissement des cartes électroniques 22. Les rainures de refroidissement 60 sont par exemple alignées verticalement avec les composants électroniques 32 dissipant le plus d'énergie thermique.

Le circuit imprimé 25 est connu en soi, et est également appelé PCB (de l'anglais *Printed Circuit Board*)*.*

La première face 26 est la face recevant principalement les composants 32 de la carte, et est également appelée face composants. Les composants 32 fixés au circuit imprimé 25 du côté de la première face 26 sont notamment les composants ayant la plus grande hauteur parmi les différents composants 32, et sont généralement des composants dits traversants, au sens où les pattes de connexion, non représentées, de ces composants traversent le circuit imprimé 25 pour être soudées aux pistes électriques, non représentées, du circuit imprimé 25 du côté de sa deuxième face 28.

La deuxième face 28 est la face avec essentiellement des soudures 34 permettant de fixer les composants 32 au circuit imprimé 25, tout en les connectant électriquement aux pistes correspondantes du circuit imprimé 25. La deuxième face 28 est alors également appelée face soudures. L'homme du métier observera que des composants 32 de faible hauteur sont également susceptibles d'être fixés au circuit imprimé 25 du côté de la deuxième face 28, et sont alors des composants 32 montés en surface.

L'âme 40 s'étend par exemple selon le plan vertical, et chaque flanc 44 s'étend alors selon un plan horizontal comportant l'axe longitudinal X et l'axe transversal Y.

L'âme 40 est réalisée de préférence en un matériau thermiquement conducteur, pour véhiculer par conduction l'énergie thermique dissipée par les cartes électroniques 22. L'âme 40 est par exemple réalisée en aluminium, cuivre, laiton nickelé.

L'âme 40 comporte deux faces d'appui 62, 64, à savoir une première face d'appui 62 pour une première carte électronique 22 et une deuxième face d'appui 64 pour une deuxième carte électronique 22, chaque face d'appui 62, 64 étant munie d'un bord 66 de fixation d'une carte électronique 22 respective. Chaque bord supérieur, respectivement inférieur, d'une carte électronique 22 respective est alors de préférence pris en sandwich entre ledit bord de fixation 66 et une bride supérieure, respectivement inférieure, de fixation 50, 52 respective.

Dans l'exemple des figures 2, 5 et 6, l'âme 40 est configurée pour maintenir les cartes électroniques 22 dans des plans sensiblement parallèles, en l'occurrence dans des plans verticaux contenant l'axe longitudinal X et l'axe vertical Z.

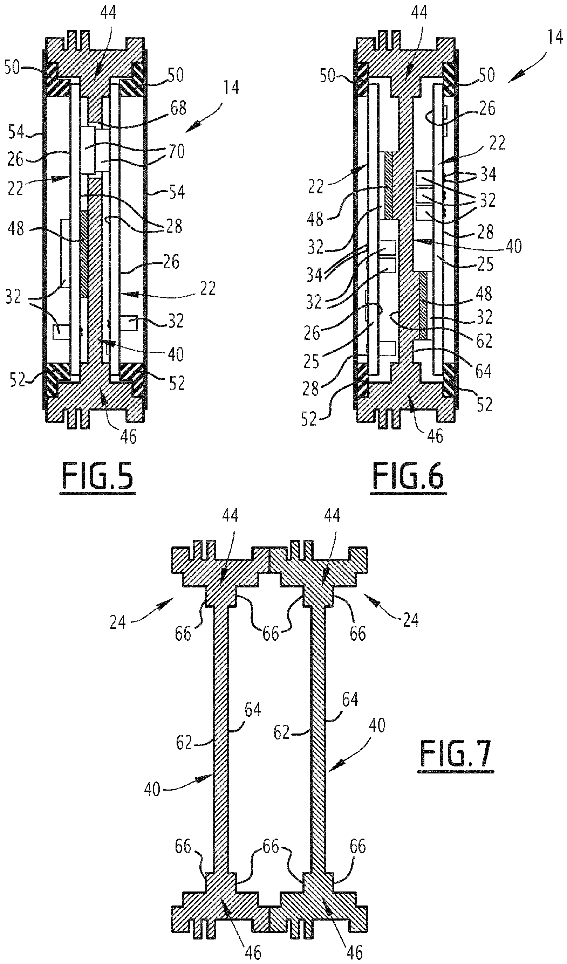

En complément facultatif, comme représenté sur la figure 5 illustrant une variante de réalisation, l'âme 40 comporte en outre une ouverture 68 de passage, configurée pour permettre le passage de connecteurs électriques 70, et/ou d'une connexion flexible, et de manière générale d'une connexion électrique pour connecter électriquement les deux cartes électroniques 22 portées par le dispositif de support 24 correspondant. L'ouverture de passage 68 est une ouverture traversant l'âme 40 de part en part, et chaque connecteur électrique 70 est associé à une carte électronique 22 respective.

Chaque flanc 44, 46 est fixé à une extrémité verticale respective de l'âme 40. Chaque flanc 44, 46 déborde de préférence de part et d'autre de l'âme 40 afin de protéger le bord de chacune des deux cartes électroniques 22 portées par le dispositif de support 24. Chaque flanc 44, 46 présente alors, suivant le plan transversal comportant l'axe transversal Y et l'axe vertical Z, une section transversale globalement symétrique par rapport à un plan médian de l'âme 40 comportant l'axe longitudinal X et l'axe vertical Z.

Chaque flanc 44, 46 est réalisé en un matériau thermiquement conducteur, également pour véhiculer par conduction l'énergie thermique dissipée par les cartes électroniques 22. Chaque flanc 44, 46 est de préférence réalisé dans le même matériau que l'âme 40. Chaque flanc 44, 46 est par exemple réalisé en aluminium, cuivre, laiton nickelé.

Chaque flanc 44, 46 est de préférence venu de matière avec l'âme 40.

Chaque tampon 48 est par exemple une pâte thermique, telle qu'une pâte à base de silicone. Chaque tampon 48 est par exemple réalisé dans un matériau en silicone et fibres de verre.

Chaque bride de fixation 50, 52 est de préférence électriquement isolante, tout en étant apte à absorber des vibrations mécaniques.

Chaque bride de fixation 50, 52 est par exemple réalisée en un matériau élastomère. En variante, chaque bride de fixation 50, 52 est réalisée en aluminium ou en acier inoxydable.

Chaque capot de protection 54 est par exemple en forme d'une plaque destinée à être fixée au flanc supérieur 44 et au flanc inférieur 46, et permettant d'offrir une protection contre l'environnement externe, tel que contre l'eau et la poussière.

En variante, chaque capot de protection 54 est en forme d'une grille de blindage, afin de protéger les cartes électroniques 22 vis-à-vis de perturbations électromagnétiques, en particulier afin de les protéger vis-à-vis de rayonnements électromagnétiques émis par des carte(s) électronique(s) voisine(s).

L'homme du métier comprendra alors que les cartes électroniques 22 sont susceptibles d'être agencées de différentes manières par rapport au dispositif de support 24. Dans l'exemple de la figure 2, les cartes électroniques 22 sont portées par le dispositif de support 24 en ayant leur première face 26, dite face composants, orientée vers l'extérieur, et en ayant alors leur deuxième face 28, dite face soudures, orientée vers l'intérieur en direction de l'âme 40.

En variante, dans l'exemple de la figure 6, les cartes électroniques 22 sont portées par le dispositif de support 24 en ayant leur première face 26 orientée vers l'intérieur en direction de l'âme 40, et en ayant alors leur deuxième face 28 orientée vers l'extérieur.

En variante, non représentée, les cartes électroniques 22 sont agencées par rapport au dispositif de support 24 avec une carte électronique 22 ayant sa première face 26 orientée vers l'intérieur en direction de l'âme 40, pendant que l'autre carte électronique 22 a sa première face 26 orientée vers l'extérieur et sa deuxième face 28 orientée vers l'intérieur en direction de l'âme 40.

Lorsque la face de la carte électronique 22 qui est en regard de l'âme 40 est la deuxième face 28, dite face soudures, le tampon 48 est alors configuré pour être en contact avec une zone de la deuxième face 28 qui est la zone en regard du composant 32 à refroidir et de l'autre côté de la carte 22, le composant à refroidir étant situé du côté de la première face 26, comme représenté sur la figure 2.

Lorsque la face de la carte électronique 22 qui est en regard de l'âme 40 est la première face 26, chaque tampon 48 est alors directement en contact entre l'âme 40, d'une part, et le composant 32 à refroidir, d'autre part, comme représenté sur la figure 6. Autrement dit, chaque tampon 48 est alors pris en sandwich entre l'âme 40 et le composant 32 à refroidir. Ceci permet d'améliorer encore le refroidissement dudit composant 32.

Ainsi, le dispositif de support 24 selon l'invention offre une plus grande robustesse mécanique de par la présence de l'âme 40 agencée entre les cartes électroniques 22 et maintenant les cartes électroniques 22 dans des plans distincts, avec une face 26, 28 d'une carte électronique 22 disposée en regard d'une face 26, 28 correspondante d'une autre carte électronique 22.

Lorsque l'âme 40 est en outre réalisée en un matériau thermiquement conducteur, le dispositif de support 24 permet alors d'améliorer le refroidissement des cartes électroniques 22 lors de leur fonctionnement, en diffusant en direction du châssis 12 l'énergie thermique dissipée par les cartes électroniques 22.

Le cas échéant, le dispositif de support 24 selon l'invention permet en outre une réduction des coûts, l'âme 40 qui joue le rôle de radiateur étant alors commune à deux cartes électroniques 22 distinctes.

Le dispositif de support 24 selon l'invention offre par ailleurs une plus grande modularité des modules électroniques 14 selon l'invention, en étant apte à être accolé à un autre dispositif de support 24, de préférence apte à être fixé à cet autre dispositif de support 24, comme représenté sur la figure 7. Ceci permet alors de former un module électronique double comportant au moins trois cartes électroniques 22.

Le cas échéant, le flanc supérieur 44 du premier dispositif de support 24 est accolé, voire fixé, latéralement au flanc supérieur 44 du deuxième dispositif de support 24, et de manière analogue le flanc inférieur 46 du premier dispositif de support 24 est accolé, voire fixé, latéralement au flanc inférieur 46 du deuxième dispositif de support 24.

Autrement dit, chaque dispositif de support 24 est empilable à sa droite ou à sa gauche avec un autre dispositif de support 24 afin de former un module électronique double.

Le dispositif de support 24 selon la variante de réalisation de la figure 5 avec en outre l'ouverture de passage 68 permet de faciliter l'interconnexion électrique des cartes électroniques 22, en permettant de les relier directement via des connecteurs 70 internes au module électronique 14, sans passer par la carte de fond de plancher 18.

On conçoit ainsi que le dispositif de support 24 selon l'invention permettant d'avoir une plus grande robustesse mécanique lorsque les cartes électroniques 22 sont maintenues par le dispositif de support 24, tout en réduisant les coûts.

## Revendications

1. Dispositif (24) de support d'au moins deux cartes électroniques (22), le dispositif de support (24) étant destiné à être inséré dans un châssis (12), chaque carte électronique (22) comportant deux faces (26, 28) et un bord périphérique (30),
le dispositif de support (24) comprenant une âme (40) configurée pour être agencée entre les cartes électroniques (22) et pour maintenir les cartes électroniques (22) dans des plans distincts, avec une face (26, 28) d'une carte électronique (22) disposée en regard d'une face (26, 28) correspondante d'une autre carte électronique (22),
l'âme (40) s'étendant selon un plan vertical, et le dispositif de support (24) comprenant en outre au moins un flanc (44, 46), chaque flanc (44, 46) s'étendant sensiblement selon un plan horizontal, étant fixé à une extrémité verticale respective de l'âme (40) et débordant par rapport à l'âme (40) pour protéger un bord de la carte électronique (22) **caractérisé en ce que** le dispositif de support (24) comprend en outre au moins une bride de fixation (50, 52) réalisée en un matériau absorbeur de vibrations mécaniques, chaque bride de fixation (50, 52) étant configurée pour maintenir une carte électronique (22) correspondante en contact avec l'âme (40).

2. Dispositif de support (24) selon la revendication 1, dans lequel le dispositif de support (24) est configuré pour être en appui mécanique contre le châssis (12), en l'absence d'un contact entre l'une quelconque des cartes électroniques (22) et le châssis (12).

3. Dispositif de support (24) selon la revendication 1 ou 2, dans lequel l'âme (40) est réalisée en un matériau thermiquement conducteur, pour véhiculer par conduction l'énergie thermique dissipée par les cartes électroniques (22).

4. Dispositif de support (24) selon l'une quelconque des revendications précédentes, dans lequel l'âme (40) comporte deux faces d'appui (62, 64), chaque face d'appui (62, 64) étant munie d'un bord de fixation (66) pour une carte électronique (22) respective.

5. Dispositif de support (24) selon l'une quelconque des revendications précédentes, dans lequel le dispositif de support (24) est configuré pour être inséré par coulissement dans le châssis (12), et comprend au moins une rainure (42) apte à coopérer avec une rainure (20) complémentaire du châssis (12).

6. Dispositif de support (24) selon l'une quelconque des revendications précédentes, dans lequel l'âme (40) est configurée pour maintenir les cartes électroniques (22) dans des plans sensiblement parallèles.

7. Dispositif de support (24) selon l'une quelconque des revendications précédentes, dans lequel le dispositif de support (24) comprend en outre au moins un tampon (48) thermiquement conducteur et électriquement isolant, chaque tampon (48) étant fixé à l'âme (40) et étant configuré pour être en regard d'au moins un composant (32) d'une carte électronique (22) respective.

8. Module électronique (14) comprenant au moins deux cartes électroniques (22) et un dispositif (24) de support des cartes électroniques (22), dans lequel le dispositif de support (24) est conforme à l'une quelconque des revendications précédentes.

9. Système électronique (10) comprenant un châssis (12) et au moins un module électronique (14), dans lequel au moins un module électronique (14) est conforme à la revendication précédente,
les cartes électroniques (22) dudit module (14) étant montées dans le châssis (12) par l'intermédiaire du dispositif de support (24) et étant portées par ledit dispositif de support (24).

10. Système électronique (10) selon la revendication 9, dans lequel le châssis (12) est d'un type choisi parmi le type 3U et le type 6U.

## Patentansprüche

1. Vorrichtung (24) zum Halten von mindestens zwei Elektronik-Karten (22), wobei die Halte-Vorrichtung (24) dazu bestimmt ist, in einen Rahmen (12) eingesetzt zu werden, wobei jede Elektronik-Karte (22) zwei Flächen (26, 28) und einen Umfangsrand (30) aufweist,
wobei die Halte-Vorrichtung (24) einen Steg (40) aufweist, der eingerichtet ist, um zwischen den Elektronik-Karten (22) angeordnet zu sein, und um die Elektronik-Karten (22) in unterschiedlichen Ebenen zu halten, wobei eine Fläche (26, 28) einer Elektronik-Karte (22) gegenüberliegend zu einer korrespondierenden Fläche (26, 28) einer anderen Elektronik-Karte (22) angeordnet ist,
wobei sich der Steg (40) entlang einer vertikalen Ebene erstreckt und die Halte-Vorrichtung (24) ferner mindestens eine Flanke (44, 46) aufweist, wobei sich jede Flanke (44, 46) im Wesentlichen entlang einer horizontalen Ebene erstreckt, an einem vertikalen Ende bezüglich des Steges (40) befestigt ist und in Bezug auf den Steg (40) hinaussteht, um einen Rand der Elektronik-Karte (22) zu schützen,
**dadurch gekennzeichnet, dass**
die Halte-Vorrichtung (24) ferner mindestens eine Befestigungs-Lasche (50, 52) aufweist, die aus einem Material zur Absorption von mechanischen Schwingungen realisiert ist, wobei jede Befestigungs-Lasche (50, 52) eingerichtet ist, um eine korrespondierende Elektronik-Karte (22) in Kontakt mit dem Steg (40) zu halten.

2. Halte-Vorrichtung (24) gemäß Anspruch 1, wobei die Halte-Vorrichtung (24) eingerichtet ist, um mechanisch gegen den Rahmen (12) anzuliegen, in Abwesenheit eines Kontakts zwischen irgendeiner der Elektronik-Karten (22) und dem Rahmen (12).

3. Halte-Vorrichtung (24) gemäß Anspruch 1 oder 2, wobei der Steg (40) aus einem thermisch leitenden Material realisiert ist, um mittels Leitung die thermische Energie zu transportieren, die von den Elektronik-Karten (22) dissipiert wird.

4. Halte-Vorrichtung (24) gemäß irgendeinem der vorherigen Ansprüche, wobei der Steg (40) zwei Anliege-Flächen (62, 64) aufweist, wobei jede AnliegeFläche (62, 64) mit einem Befestigungs-Rand (66) für eine jeweilige Elektronik-Karte (22) versehen ist.

5. Halte-Vorrichtung (24) gemäß irgendeinem der vorherigen Ansprüche, wobei die Halte-Vorrichtung (24) eingerichtet ist, um mittels Gleitens in den Rahmen (12) eingesetzt zu werden, und mindestens eine Nut (42) aufweist, die imstande ist, um mit einer komplementären Nut (20) des Rahmens (12) zu kooperieren.

6. Halte-Vorrichtung (24) gemäß irgendeinem der vorherigen Ansprüche, wobei der Steg (40) eingerichtet ist, um die Elektronik-Karten (22) in Ebenen zu halten, die im Wesentlichen parallel sind.

7. Halte-Vorrichtung (24) gemäß irgendeinem der vorherigen Ansprüche, wobei die Halte-Vorrichtung (24) ferner mindestens einen thermisch leitenden und elektrisch isolierenden Puffer (48) aufweist, wobei jeder Puffer (48) an dem Steg (40) befestigt ist und eingerichtet ist, um gegenüberliegend zu mindestens einem Bauteil (32) einer jeweiligen Elektronik-Karte (22) zu sein.

8. Elektronik-Modul (14), welches mindestens zwei Elektronik-Karten (22) und eine Vorrichtung (24) zum Halten der Elektronik-Karten (22) aufweist, wobei die Halte-Vorrichtung (24) gemäß irgendeinem der vorherigen Ansprüche ist.

9. Elektronik-System (10), welches einen Rahmen (12) und mindestens ein Elektronik-Modul (14) aufweist, wobei mindestens ein Elektronik-Modul (14) gemäß dem vorherigen Anspruch ist,
wobei die Elektronik-Karten (22) des besagten Moduls (14) in dem Rahmen (12) mittels der Halte-Vorrichtung (24) montiert sind und mittels der besagten Halte-Vorrichtung (24) getragen werden.

10. Elektronik-System (10) gemäß Anspruch 9, wobei der Rahmen (12) von einem Typ ist, der ausgewählt ist aus dem 3U-Typ und dem 6U-Typ.

## Claims

1. Device (24) for supporting at least two electronic cards (22), the support device (24) being intended to be inserted into a chassis (12), each electronic card (22) having two faces (26, 28) and a peripheral edge (30),
the support device (24) comprising a core (40) which is configured to be arranged between the electronic cards (22) and to maintain the electronic cards (22) in distinct planes, with one face (26, 28) of one electronic card (22) arranged opposite a corresponding face (26, 28) of another electronic card (22),
the core (40) extending in a vertical plane, and the support device (24) further comprising at least one flank (44, 46), each flank (44, 46) extending substantially in a horizontal plane, being fixed to a respective vertical end of the core (40) and protruding relative to the core (40) in order to protect an edge of the electronic card (22), **characterised in that**
the support device (24) further comprises at least one fixing flange (50, 52) made of a material which absorbs mechanical vibrations, each fixing flange (50, 52) being configured to maintain a corresponding electronic card (22) in contact with the core (40).

2. Support device (24) according to claim 1, wherein the support device (24) is configured to abut mechanically against the chassis (12), in the absence of contact between any one of the electronic cards (22) and the chassis (12).

3. Support device (24) according to claim 1 or 2, wherein the core (40) is made of a thermally conducting material, in order to convey by conduction the thermal energy dissipated by the electronic cards (22).

4. Support device (24) according to any one of the preceding claims, wherein the core (40) has two abutment faces (62, 64), each abutment face (62, 64) being provided with a fixing edge (66) for a respective electronic card (22).

5. Support device (24) according to any one of the preceding claims, wherein the support device (24) is configured to be inserted by sliding into the chassis (12) and comprises at least one groove (42) capable of cooperating with a complementary groove (20) of the chassis (12).

6. Support device (24) according to any one of the preceding claims, wherein the core (40) is configured to maintain the electronic cards (22) in substantially parallel planes.

7. Support device (24) according to any one of the preceding claims, wherein the support device (24) further comprises at least one thermally conducting and electrically insulating buffer (48), each buffer (48) being fixed to the core (40) and being configured to face at least one component (32) of a respective electronic card (22).

8. Electronic module (14) comprising at least two electronic cards (22) and a device (24) for supporting the electronic cards (22), wherein the support device (24) is in accordance with any one of the preceding claims.

9. Electronic system (10) comprising a chassis (12) and at least one electronic module (14), wherein at least one electronic module (14) is in accordance with the preceding claim,
the electronic cards (22) of said module (14) being mounted in the chassis (12) by way of the support device (24) and being carried by said support device (24).

10. Electronic system (10) according to claim 9, wherein the chassis (12) is of a type selected from the 3U type and the 6U type.
